# EUROPÄISCHE PATENTANMELDUNG

(11) **EP 3 489 995 A1**
(43) Veröffentlichungstag der Anmeldung: **29.05.2019**
(21) Anmeldenummer: 17203059.5
(22) Anmeldetag: 22.11.2017
(51) Int. Cl.: H01L 23/367, H01L 23/467, H05K 7/20, G06F 1/20

(54) **LEISTUNGSELEKTRONISCHER AUFBAU**

(71) Anmelder: Siemens Aktiengesellschaft, 80333 München (DE)
(72) Erfinder: Kiesel, Alexander, 91054 Erlangen (DE)

(57) **Zusammenfassung**

Es wird ein leistungselektronischer Aufbau angegeben mit zwei Leiterplatten mit jeweils einem oder mehreren leistungselektronischen Bauelementen, wobei die Leiterplatten im Wesentlichen parallel zueinander angeordnet sind und einen Zwischenraum ausbilden und einem im Zwischenraum angeordneten und von den Leiterplatten durch einen Luftspalt getrennten Kühlkörper, wobei der Kühlkörper im Wesentlichen flächig gestaltet ist, eine Flächenausdehnung von wenigstens 70% der Fläche einer der Leiterplatten, bei unterschiedlichen Größen der kleineren der beiden Leiterplatten aufweist und frei von leistungselektronischen Bauelementen ist.

## Beschreibung

Die Erfindung betrifft einen leistungselektronischen Aufbau mit einer Mehrzahl von parallel angeordneten Leiterplatten.

Bei leistungselektronischen Aufbauten werden die entstehenden Verluste der Leistungshalbleiter mittels Wärmeleitung in die Leiterplatte geführt und über angeschlossene Kupferflächen verteilt. Hierdurch steigt großflächig die Temperatur der Leiterplatte. Durch den Temperaturhub wird die Wärme im Anschluss durch Konvektion an die Luft, bzw. Strahlung an umgebende Flächen abgegeben. Beim Kühlen über die Leiterplattenfläche nimmt der zur Wärmeabfuhr beitragende Strahlungsanteil zu, da sich die abstrahlende Fläche der heißen Kupferanschlussbereiche der Leiterplatte deutlich vergrößert. Somit strahlt in diesem Aufbau annähernd die gesamte Leiterplattenfläche Energie an die Umgebung ab, wodurch bis zu 30% des gesamten Wärmeabtransports über diesen Mechanismus stattfindet.

Bei mehreren nebeneinander platzierten Leiterplatten mit Verlustleistung, beispielsweise bei einem modularen Steckkartensystem, sinkt jedoch die Effizienz der Energieabgabe nachteilig, da sich die Leiterplatten gegenseitig anstrahlen, wodurch bei gleicher Temperatur keine Wärmeabgabe an eine Wärmesenke stattfindet. Eine Konsequenz dessen ist, dass die Leiterplatten diesen Anteil zusätzlich über Konvektion abführen müssen, was zu einer Temperaturerhöhung von bis zu 30 °C führen kann.

Es ist Aufgabe der vorliegenden Erfindung, einen leistungselektronischen Aufbau mit einer verbesserten Entwärmung anzugeben.

Diese Aufgabe wird gelöst durch einen leistungselektronischen Aufbau mit den Merkmalen von Anspruch 1.

Der erfindungsgemäße leistungselektronischer Aufbau umfasst wenigstens zwei Leiterplatten mit jeweils einem oder mehreren leistungselektronischen Bauelementen, wobei die Leiterplatten im Wesentlichen parallel zueinander angeordnet sind und einen Zwischenraum ausbilden. Weiterhin umfasst der leistungselektronische Aufbau einen im Zwischenraum angeordneten und von den Leiterplatten durch einen Luftspalt getrennten Kühlkörper, wobei der Kühlkörper im Wesentlichen flächig gestaltet ist, eine Flächenausdehnung von wenigstens 70% der Fläche einer der Leiterplatten, bei unterschiedlichen Größen der kleineren der beiden Leiterplatten aufweist und frei von Leistungshalbleitern ist.

Mit anderen Worten handelt es sich bei dem Kühlkörper nicht etwa um eine weitere Leiterplatte mit Leistungshalbleitern. Vielmehr ist der Kühlkörper frei vom direkten Wärmeeintrag durch aufgebrachte Leistungshalbleiter.

Bei den Leiterplatten kann es sich um Leiterplatten bekannter Arten wie beispielsweise PCBs handeln.

Der Kühlkörper ist durch einen Luftspalt von den Leiterplatten getrennt, mit anderen Worten also nicht mechanisch oder kraftschlüssig mit den Leiterplatten oder mit elektronischen Bauteilen der Leiterplatten verbunden.

Durch den erfindungsgemäßen leistungselektronischen Aufbau wird vorteilhaft erreicht, dass die Leiterplatten sich nicht gegenseitig anstrahlen, sondern beide den Kühlkörper anstrahlen. Der Kühlkörper wiederum wird konvektiv gekühlt und erfährt keinen unmittelbaren Wärmeeintrag von Leistungshalbleitern. Er ist somit kälter als die Leiterplatten und empfängt in Summe Wärmestrahlung von beiden Leiterplatten. Dadurch wird in Summe eine verbesserte Wärmeabfuhr für die Leiterplatten erreicht.

Vorteilhafte Ausgestaltungen des erfindungsgemäßen leistungselektronischen Aufbaus gehen aus den von Anspruch 1 abhängigen Ansprüchen hervor. Dabei kann die Ausführungsform nach Anspruch 1 mit den Merkmalen eines der Unteransprüche oder vorzugsweise auch mit denen aus mehreren Unteransprüchen kombiniert werden. Demgemäß können für den leistungselektronischen Aufbau noch zusätzlich folgende Merkmale vorgesehen werden:
- Der Kühlkörper kann ein metallisches Material aufweisen, beispielsweise Aluminium oder Stahl. Insbesondere kann der Kühlkörper im Wesentlichen ganz aus dem metallischen Material bestehen. Ein metallischer Kühlkörper führt zu einer weitgehend gleichmäßigen Temperatur im Kühlkörper und dadurch zu einer guten Wärmeabgabe an die umgebende Luft. Alternativ kann der Kühlkörper einen isolierenden Überzug aufweisen, beispielsweise aus einem Kunststoffmaterial. Hierdurch wird eine elektrische und/oder magnetische Schirmung bei gleichzeitiger elektrischer Isolation erreicht. Die Isolation kann beispielsweise vorteilhaft sein, wenn die Leiterplatten Bauelemente aufweisen, die sich durch ihre Bauhöhe sehr nahe kommen.
- Der Kühlkörper kann ein Kunststoff-Material oder ein keramisches Material aufweisen. Vorteilhaft werden dadurch elektrische Probleme vermieden, meist auch Gewicht und Kosten gegenüber metallischen Lösungen gespart. Vorteilhaft kann der Kühlkörper in einfacher Weise verwendet werden, um zusätzlich Aufgaben zu übernehmen, beispielsweise als Träger für andere elektronische Aufbauten, die keine Leistungshalbleiter enthalten oder als Stützelement für die Leiterplatten.
- Der Kühlkörper kann ausgestaltet sein, einen Emissionsgrad (epsilon) von wenigstens 0,8, insbesondere wenigstens 0,9 aufzuweisen. Dabei muss der Emissionsgrad nicht auf der ganzen Oberfläche vorliegen, aber doch zweckmäßig auf einem Großteil, beispielsweise im Wesentlichen auf den ganzen den Leiterplatten zugewandten Flächen. Ein hoher Emissionsgrad entspricht einer hohen thermischen Absorptionsfähigkeit und somit einer guten Wärmeabgabe von den Leiterplatten zum Kühlkörper und daher der bestmöglichen Kühlleistung.

- Der Kühlkörper ist bevorzugt im Wesentlichen parallel zu den Leiterplatten angeordnet. Mit anderen Worten bleibt der Abstand der Oberflächen, abgesehen von Oberflächenunebenheiten wie beispielsweise Leiterbahnen oder Leistungshalbleiter, konstant. Dadurch wird die Luftbewegung im Zwischenraum begünstigt, besonders dann, wenn eine freie Konvektion ohne Lüfter verwendet wird.
- Kühlkörper hat bevorzugt einen Abstand von jeder der Leiterplatten von wenigstens 10 mm, insbesondere wenigstens 15 mm. Dadurch wird vor allem die freie Luftbewegung durch den Zwischenraum, d.h. ohne Verwendung eines Lüfters begünstigt.
- Die Leiterplatten haben bevorzugt einen Abstand voneinander von höchstens 60 mm, insbesondere höchstens 45 mm. Dadurch wird eine möglichste geringe Ausdehnung des leistungselektronischen Aufbaus bewirkt. Der Aufbau wird also besonders kompakt.
- Der Kühlkörper ist dabei bevorzugt mittig zwischen den Leiterplatten angeordnet, was wiederum den Luftfluss im Zwischenraum begünstigt.
- Bevorzugt befindet sich der Kühlkörper also mittig zwischen den Leiterplatten in einem Abstand von zwischen 10 mm und 20 mm, insbesondere 15 mm oder 20 mm, von jeder der Leiterplatten. Damit wird der Aufbau kompakt bei möglichst guter Luftkühlung ohne Lüfter.
- Der Kühlkörper kann Kühlrippen und/oder andere oberflächenvergrößernde Strukturen, insbesondere eine Wellung der Oberfläche, aufweisen. Hierdurch wird die Wärmeabgabe an die Luft verbessert.
- Die leistungselektronischen Bauelemente sind bevorzugt kühlkörperfrei auf den Leiterplatten angeordnet. Insbesondere werden bevorzugt einzelne Leistungshalbleiterchips direkt auf den Leiterplatten verwendet im Gegensatz zu typischen derzeitigen Aufbauten, bei denen vorgefertigte Module verwendet werden. Diese Chips weisen dann selbst keinen Kühlkörper auf.
- Der leistungselektronische Aufbau kann zur passiven Kühlung ausgestaltet sein. Mit anderen Worten weist der leistungselektronische Aufbau keinen aktiven Lüfter auf, also keine bewegten Teile. Das ist vorteilhaft für die Wartungsfreiheit und Lebensdauer des Aufbaus. Weiterhin wird dadurch das Laufgeräusch des Lüfters vermieden.
- Der leistungselektronische Aufbau kann eine oder mehrere weitere Leiterplatten aufweisen, die zusammen mit den Leiterplatten einen oder mehrere weitere Zwischenräume ausbilden. Der leistungselektronische Aufbau umfasst weiterhin einen oder mehrere in den weiteren Zwischenräumen angeordnete und von den Leiterplatten und/oder weiteren Leiterplatten durch einen Luftspalt getrennte weitere Kühlkörpern. Es wird der grundsätzliche Aufbau mit anderen Worten fortgesetzt mit einer Mehrzahl von Leiterplatten, zwischen denen paarweise je ein Kühlkörper angeordnet ist. Dadurch wird für jedes Paar nebeneinander liegender Leiterplatten vermieden, dass diese sich gegenseitig anstrahlen und somit für eine verbesserte Entwärmung gesorgt. Insgesamt kann der leistungselektronische Aufbau so beispielsweise mindestens sechs Leiterplatten oder in anderen Ausgestaltungen mindestens 10 Leiterplatten umfassen.
- Der Kühlkörper kann eine Dicke von weniger als 5 mm, insbesondere weniger als 1 mm aufweisen.
- Der Kühlkörper kann in einem Winkel von zwischen 35° und 55° zu den Leiterplatten angeordnet sein. Dabei ist es besonders bevorzugt, wenn der Kühlkörper verspiegelt ist. Dadurch wird ein Teil der Wärmestrahlung je nach Grad der Verspiegelung reflektiert. Durch die Lage des Kühlkörpers relativ zu den Leiterplatten wird die Wärmestrahlung nicht zu den Leiterplatten zurück, sondern zur Seite oder nach oben oder unten reflektiert und erreicht somit die Leiterplatten nicht mehr. Da der Kühlkörper entsprechend dem Grad der Verspiegelung reduzierte Wärmestrahlung abgibt, erreicht nur ein kleiner Anteil der Wärmestrahlung die Leiterplatten.

Weitere Vorteile und Merkmale sind der folgenden Beschreibung von Ausführungsbeispielen anhand der Figuren zu entnehmen. In den nicht maßstäblichen Figuren bezeichnen gleiche Bezugszeichen gleiche Bauteile und Funktionen.

Es zeigen:

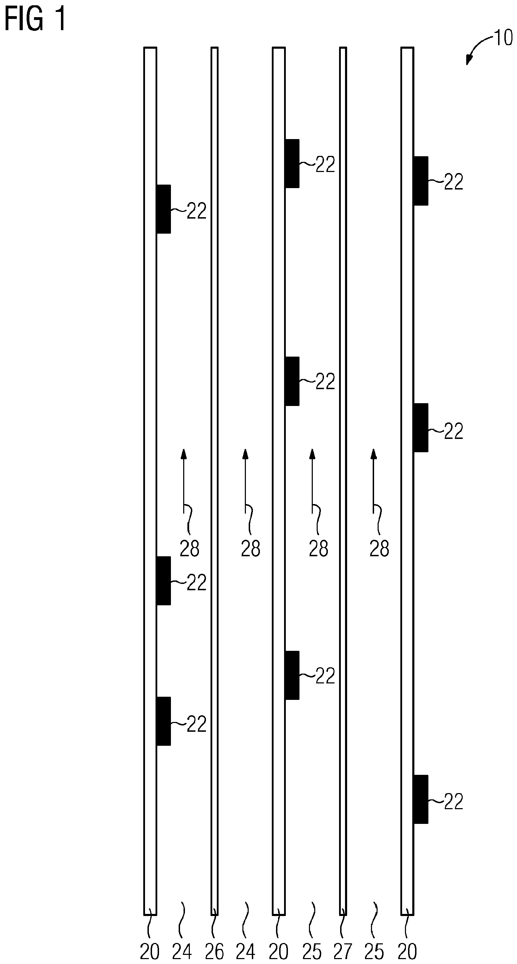

Figuren 1 bis 4 Seitenansichten von leistungselektronischen Aufbauten.

Figur 1 zeigt einen beispielhaften Aufbau gemäß der Erfindung in einer Seitenansicht. Eine Aufsicht auf den Aufbau würde der Figur 1 bis auf die Länge der Elemente ebenfalls entsprechen. Der Aufbau gemäß Figur 1 stellt einen beispielhaften modular aufgebauten Umrichter 10 dar. Der Umrichter 10 umfasst drei Leiterplatten 20, in diesem Beispiel FR4-PCBs. Die Leiterplatten 20 sind jeweils mit einem oder mehreren, im vorliegenden Beispiel mit jeweils vier Leistungshalbleitern 22, bestückt. Bei den Leistungshalbleitern 22 handelt es sich generell um Transistoren, im vorliegenden Beispiel um GaN-Schalter. Die Leistungshalbleiter 22 sind in diesem Beispiel ohne eigenen Kühlkörper oder ähnliche Aufbauten auf der jeweiligen Leiterplatte 20 angeordnet. Im vorliegenden Beispiel sind die Leistungshalbleiter 22 stets auf einer einzigen Seite der jeweiligen Leiterplatte 20 angeordnet. In anderen Ausführungen können die Leiterplatten 20 aber auch beidseitig Leistungshalbleiter 22 aufweisen.

Im vorliegenden Beispiel bedeutet der modulare Aufbau des Umrichters, dass die Leiterplatten 20 gleichartig aufgebaut und bestückt sind. Die Leistungshalbleiter 22 auf den Leiterplatten 20 sind jeweils gleichartig miteinander verschaltet, in diesem Beispiel zu jeweils zwei Halbbrücken pro Leiterplatte mit jeweils zwei Leistungshalbleitern 22 pro Halbbrücke. Durch eine geeignete elektrische Kontaktierung außerhalb der Leiterplatten 20 wird aus den insgesamt sechs Halbbrücken zusammen mit einem außerhalb der Leiterplatten 20 angeordneten Kondensator ein Umrichter aufgebaut. Typisch für modulare Aufbauten ist es, dass anstelle einer speziell auf die Anforderungen angepassten eigens entwickelten Schaltung gleichartige Teilschaltungen wie die Leiterplatten 20 zum Einsatz kommen, bei denen beispielsweise über die Anzahl der Leiterplatten 20 die Anforderungen an die Schaltung erfüllt werden.

Dabei ist es auch möglich, dass nur ein Teil der Leiterplatten 20 gleichartig aufgebaut sind und ein weiterer Teil der Leiterplatten 20 einen davon verschiedenen Aufbau aufweist. Beispielsweise könnten in einer alternativen Ausgestaltung drei gleichartige Eingangsleiterplatten und drei gleichartige, aber von den Eingangsleiterplatten verschiedene Ausgangsleiterplatten verwendet werden.

Die Leiterplatten 20 sind im Wesentlichen rechteckig, alternativ auch quadratisch, gleich groß und parallel zueinander in einem Abstand von 40 mm angeordnet. Sie bilden dadurch zwei Zwischenräume 24, 25 aus. Im ersten Zwischenraum 24 ist ein erster Kühlkörper 26 angeordnet und im zweiten Zwischenraum 25 ist ein zweiter Kühlkörper 27 angeordnet. Die Kühlkörper 26, 27 sind in diesem Beispiel Platten aus Kunststoff, die dieselbe Größe aufweisen wie die Leiterplatten 20. Sie sind mittig im jeweiligen Zwischenraum 24, 25 angeordnet und weisen somit von den beiden umliegenden Leiterplatten einen Abstand von ca. 20 mm auf. Die Dicke der Kühlkörper 26, 27 beträgt in diesem Beispiel 1 mm, wobei die Dicke in anderen Ausführungen größer sein kann, beispielsweise 2 mm oder auch kleiner sein kann, beispielsweise 500 µm oder 250 µm. Die Oberfläche der Kühlkörper ist geschwärzt, um einen Emissionsgrad der Oberfläche von nahezu epsilon = 1 zu erreichen.

Im gezeigten Aufbau erzeugen die Leistungshalbleiter 22 im Betrieb Abwärme, die die Leistungshalbleiter 22 selbst sowie umliegende Bereiche der Leiterplatten 20 erwärmt. Die erwärmten Leiterplatten 20 geben Wärme an die umgebende Luft ab und geben weiterhin auch Wärme in Form von Strahlung ab entsprechend der jeweiligen lokalen Temperatur der Leiterplatte 20 bzw. der Oberfläche der Leistungshalbleiter 22. In einem Aufbau ohne die Kühlkörper strahlen sich die Leiterplatten 20 gegenseitig an. Soweit die Leiterplatten 20 in ihrem Temperaturprofil übereinstimmen, wird durch Strahlung netto keine Leistung abgeführt, da die Oberfläche der Leiterplatte 20 so viel Leistung abstrahlt wie sie aufnimmt.

Wie leicht ersichtlich ist, gilt das nicht für die außenliegenden Leiterplatten 20, die zu einer Seite hin keine weitere Leiterplatte 20 mehr haben. Hier wird aber typischerweise eine Gehäusewandung vorhanden sein, deren Temperatur dann die Wärmeabgabe durch Strahlung mitbestimmt. Weiterhin ergeben sich kleine Abweichungen von der einfachen Regel in den Randbereichen der Leiterplatten 20, in denen Strahlung ebenfalls nicht mehr direkt auf eine weitere Leiterplatte 20 trifft, sondern beispielsweise auf eine Gehäusewandung.

Vorteilhaft strahlen im Aufbau gemäß Figur 1 die Oberflächen der Leiterplatten 20, die einem Kühlkörper 26, 27 zugewandt sind, den Kühlkörper 26, 27 an. Die Oberfläche des Kühlkörpers 26, 27 wiederum strahlt zurück zu den Leiterplatten 20. Die Nettoabgabe von Leistung von den Leiterplatten 20 hängt daher in dem gezeigten Aufbau von der Temperatur des Kühlkörpers 26, 27 ab und ist nicht automatisch nahe Null. Da eine Kühlung der Leiterplatten 20 des Umrichters 10 beispielsweise durch Luftzirkulation auch die Kühlkörper 26, 27 mitbeeinflusst, aber die Kühlkörper 26, 27 keinen direkten Wärmeeintrag durch Leistungshalbleiter 22 aufweisen, ist die Temperatur der Kühlkörper 26, 27 im Betrieb geringer als die der Leiterplatten 20. Da die Oberfläche der Kühlkörper somit eine schwächere Wärmestrahlung abgibt als die der Leiterplatten 20, findet eine strahlungsbedingte Wärmeabgabe von den Leiterplatten 20 statt. Diese Wärmeabgabe ist stark von der Geometrie des Aufbaus und von den Temperaturunterschieden abhängig, kann aber bis zu 30 % der gesamten Wärmeabgabe der Leiterplatten 20 ausmachen und kann somit erheblich zur Entwärmung des Umrichters 10 beitragen.

Je nach Auslegung kann der zusätzliche Kühleffekt bewirken, dass der gesamte Aufbau mit einer passiven Kühlung betrieben werden kann. Mit anderen Worten befindet sich also kein Lüfter an einer Seite des Aufbaus, der einen aktiven Luftstrom bewirkt, sondern der Luftstrom entsteht rein passiv durch Kaminwirkung, d.h. dadurch, dass die von den Leiterplatten 20 und von den Kühlkörpern 26, 27 erwärmte Luft aufsteigt und dadurch einen stetigen Luftstrom 28 ausbildet. Eine passive Kühlung hat gegenüber einer Kühlung mit einem Lüfter Vorteile bei der Ausfallsicherheit und Geräuschentwicklung.

Vorteilhaft an dem gezeigten Aufbau ist, dass die Oberfläche, die für die Wärmeabgabe an die Luft und damit für die konvektive Kühlung durch den Luftstrom 28 zur Verfügung steht, durch die Kühlkörper 26, 27 deutlich vergrößert wird. Im Beispiel gemäß der Figur 1 wird die Oberfläche der drei Leiterplatten 20 durch zwei Kühlkörper mit im Wesentlichen gleicher Oberfläche ergänzt, die Oberfläche wird also um etwa 40% erhöht. Die entsprechende zusätzliche konvektive Wärmeabfuhr bildet die Basis für die durch Strahlung zusätzlich aus den Leiterplatten 20 entfernte Wärme.

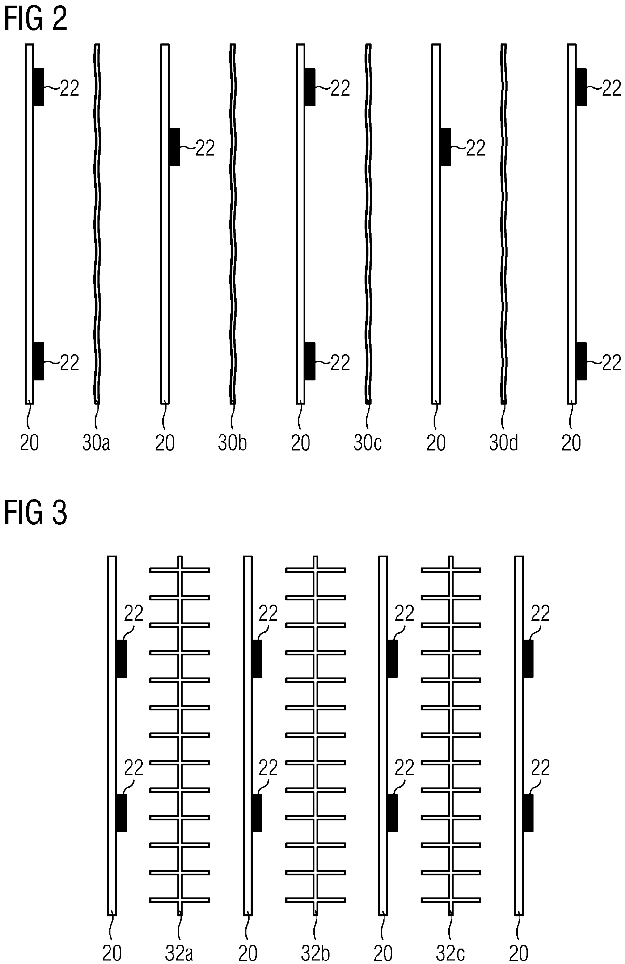

Um eine verstärkte Wärmeabfuhr aus den Kühlkörpern 26, 27 zu erreichen, kann die Oberfläche der Kühlkörper 26, 27 vergrößert werden. Figur 2 zeigt eine erste Variante dafür, bei der die Oberfläche der Kühlkörper 30a...d durch eine Wellung vergrößert ist. Figur 3 zeigt eine weitere Aufbau-Variante, bei der die Kühlkörper 32a...c zusätzliche Kühlrippen 33 zur Vergrößerung der Oberfläche aufweisen. Durch jede Vergrößerung der Oberfläche wird ein verstärkter Wärmeabtransport durch den Luftstrom 28 erreicht. Dadurch ergibt sich für die Kühlkörper 30a...d, 32a...c gegenüber der Ausgestaltung nach Figur 1 eine niedrigere Temperatur. Diese wiederum führt zu einem stärkeren Netto-Eintrag von Wärme durch Strahlung. Insgesamt ergibt sich dadurch vorteilhaft eine etwas abgesenkte Kühlkörpertemperatur bei stärkerer Wärmeabgabe aus den Leiterplatten 20. Dabei ist es besonders vorteilhaft, wenn der Abstand der Kühlrippen 33 mindestens 10 mm beträgt, da dann eine passive Kühlung möglich ist. Wird ein kleinerer Abstand gewählt, ist der Strömungswiderstand für die Luft so hoch, dass der Wärmeabtransport zu gering wird. Das kann mit einer aktiven Kühlung mittels Lüfter behoben werden.

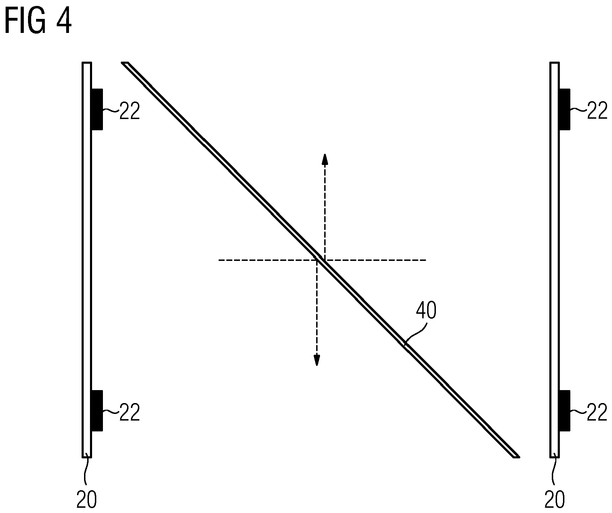

Ein weiteres Ausführungsbeispiel ist in Figur 4 dargestellt. Figur 4 zeigt beispielhaft nur einen Kühlkörper 40 zwischen zwei Leiterplatten 20, der Aufbau ist aber auch für eine Mehrzahl von Kühlkörpern 40 möglich. Der Kühlkörper 40 ist hierbei in einem Winkel von 45° zu den Leiterplatten 20 angeordnet. Hierbei ist es wie in den bisherigen Beispielen möglich, dass der Kühlkörper 40 so gestaltet ist, dass er einen möglichst hohen Emissionsgrad aufweist, beispielsweise als Platte aus geschwärztem Aluminium. Eine besondere Variante stellt es jedoch dar, wenn der Kühlkörper stattdessen möglichst gut verspiegelt ist, beispielsweise in Form einer polierten Aluminium- oder Stahlplatte. In diesem Fall wird die von den Leiterplatten 20 ausgehende Wärmestrahlung kaum im Kühlkörper 40 absorbiert, sondern im Wesentlichen reflektiert. Durch die Anordnung des Kühlkörpers 40 wird die Strahlung aber von den Leiterplatten 20 weg beispielsweise nach oben und unten reflektiert. Dort kann sie beispielsweise durch transparente Gehäuseelemente aus dem Gehäuse austreten oder zumindest in der Gehäusewandung absorbiert werden. Ebenso wie bei den anderen Ausführungsbeispielen wird also eine strahlungsbedingte zusätzliche Entwärmung für die Leiterplatten 20 erreicht.

## Patentansprüche

1. Leistungselektronischer Aufbau (10), umfassend:
- zwei Leiterplatten (20) mit jeweils einem oder mehreren leistungselektronischen Bauelementen (22), wobei die Leiterplatten (20) im Wesentlichen parallel zueinander angeordnet sind und einen Zwischenraum (24) ausbilden,
- einen im Zwischenraum (24) angeordneten und von den Leiterplatten (20) durch einen Luftspalt getrennten Kühlkörper (26, 27, 30a...d, 32a...c, 40), wobei der Kühlkörper (26, 27, 30a...d, 32a...c, 40) im Wesentlichen flächig gestaltet ist, eine Flächenausdehnung von wenigstens 70% der Fläche einer der Leiterplatten (20), bei unterschiedlichen Größen der kleineren der beiden Leiterplatten (20) aufweist und frei von leistungselektronischen Bauelementen (22) ist.

2. Leistungselektronischer Aufbau (10) nach Anspruch 1, bei dem der Kühlkörper (26, 27, 30a...d, 32a...c, 40) ein metallisches Material aufweist, beispielsweise Aluminium oder Stahl.

3. Leistungselektronischer Aufbau (10) nach Anspruch 1 oder 2, bei dem der Kühlkörper (26, 27, 30a...d, 32a...c, 40) ein Kunststoff-Material aufweist.

4. Leistungselektronischer Aufbau (10) nach einem der vorangehenden Ansprüche, bei dem der Kühlkörper (26, 27, 30a...d, 32a...c, 40) ausgestaltet ist, einen Emissionsgrad von wenigstens 0,8, insbesondere wenigstens 0,9 aufweist.

5. Leistungselektronischer Aufbau (10) nach einem der vorangehenden Ansprüche, bei dem der Kühlkörper (26, 27, 30a...d, 32a...c, 40) im Wesentlichen parallel zu den Leiterplatten (20) angeordnet ist.

6. Leistungselektronischer Aufbau (10) nach einem der vorangehenden Ansprüche, bei dem der Kühlkörper (26, 27, 30a...d, 32a...c, 40) einen Abstand von jeder der Leiterplatten (20) von wenigstens 10 mm, insbesondere wenigstens 15 mm hat.

7. Leistungselektronischer Aufbau (10) nach einem der vorangehenden Ansprüche, bei dem die Leiterplatten (20) einen Abstand voneinander von höchstens 60 mm, insbesondere höchstens 45 mm haben.

8. Leistungselektronischer Aufbau (10) nach einem der vorangehenden Ansprüche, bei dem der Kühlkörper (26, 27, 30a...d, 32a...c, 40) mittig zwischen den Leiterplatten (20) angeordnet ist.

9. Leistungselektronischer Aufbau (10) nach einem der vorangehenden Ansprüche, bei dem der Kühlkörper (26, 27, 30a...d, 32a...c, 40) Kühlrippen und/oder eine Wellung der Oberfläche aufweist.

10. Leistungselektronischer Aufbau (10) nach einem der vorangehenden Ansprüche, bei dem die leistungselektronischen Bauelemente (22) kühlkörperfrei auf den Leiterplatten (20) angeordnet sind.

11. Leistungselektronischer Aufbau (10) nach einem der vorangehenden Ansprüche, ausgestaltet zur passiven Kühlung.

12. Leistungselektronischer Aufbau (10) nach einem der vorangehenden Ansprüche mit einer oder mehreren weiteren Leiterplatten (20), die zusammen mit den Leiterplatten (20) einen oder mehrere weitere Zwischenräume (24, 25) ausbilden sowie mit einem oder mehreren im Zwischenraum (24, 25) angeordneten und von den Leiterplatten (20) durch einen Luftspalt getrennten weiteren Kühlkörpern (27).

13. Leistungselektronischer Aufbau (10) nach Anspruch 1, bei dem der Kühlkörper (26, 27, 30a...d, 32a...c, 40, 27) in einem Winkel von zwischen 35° und 55° zu den Leiterplatten (20) angeordnet ist.

14. Leistungselektronischer Aufbau (10) nach einem der vorangehenden Ansprüche, bei dem die Leiterplatten im Wesentlichen gleich groß sind.
